# EUROPEAN PATENT APPLICATION

(11) **EP 4 621 527 A1**
(43) Date of publication of application: **24.09.2025**
(21) Application number: 25165810.0
(22) Date of filing: 24.03.2025
(51) Int. Cl.: G06F 1/20, H05K 7/20, H01L 23/467

(54) **SUPERCOMPUTING DEVICE AND DATA CENTER**

(30) Priority: 22.03.2024 CN 202420578426 U
(71) Applicant: Bitdeer Semiconductor Technology PTE. LTD., 049514 Singapore (SG)
(72) Inventor: LI, Weiguo, 049514 Singapore (SG); YANG, Senfeng, 049514 Singapore (SG)
(74) Representative: Wang, Bo

(57) **Abstract**

The present application provides a supercomputing device and a data center. The supercomputing device comprises a housing and a supercomputing unit; the housing has an air inlet and an air outlet which are disposed opposite to each other; the supercomputing unit is mounted in the housing and located between the air inlet and the air outlet; the supercomputing unit comprises a hash board, a first heat sink and a seal, the hash board comprises a substrate and a plurality of hash chips, a first surface of the substrate is provided with a chip region and a bare board region in a first direction, the bare board region is closer to the air inlet than the chip region, and the plurality of hash chips are disposed in the chip region; the first heat sink is mounted on the first surface of the substrate, and the first heat sink has an extension structure opposite to the bare board region; the seal is disposed at edge regions of the extension structure and the bare board region close to the air inlet; the first direction is a direction in which the air inlet and the air outlet are opposite to each other. The supercomputing device according to the present application can prevent foreign matter such as dust from depositing on the hash board and hash chips, thereby improving the reliability and computing efficiency of the whole device.

## Description

### FIELD

The present application relates to the technical field of servers, and particularly to a supercomputing device and a data center.

### BACKGROUND

With the development of science and technology, requirements for computing power of servers are becoming higher and higher. Particularly hash chips of a supercomputing device for virtual currency needs to perform massive computation. The requirements for heat dissipation of the hash chips are extremely high in order to ensure their normal operations. In the prior art, a heat sink is often attached to a hash board where the hash chips are located, and the hash board and the heat sink are located on an entire airflow channel to take away heat from the heat sink as quickly as possible.

However, as the requirements for heat dissipation increases constantly, while the airflow in the airflow channel is increased, more foreign matter such as dust will be brought into the airflow channel. The dust is prone to accumulate on the hash board, particularly on the hash chips. With the accumulation of the foreign matter such as dust, faults such as short-circuiting of the hash board might be caused, and the coverage of the foreign matter such as dusts also affects the heat dissipation effect of the hash chips and causes problems such as reduction of the computational efficiency.

### SUMMARY

Based on the present state of the art, a main object of the present application is to provide a supercomputing device and a data center, to prevent foreign matter such as dust from depositing on a hash board and hash chips as much as possible, thereby improving the reliability and computing efficiency of the whole device.

The present application employs the following technical solutions to achieve the above object:
A first aspect of the present application provides a supercomputing device, comprising a housing and a supercomputing unit;
the housing has an air inlet and an air outlet which are disposed opposite to each other;
the supercomputing unit is mounted in the housing and located between the air inlet and the air outlet;
the supercomputing unit comprises a hash board, a first heat sink and a seal, the hash board comprises a substrate and a plurality of hash chips, a first surface of the substrate is provided with a chip region and a bare board region in a first direction, the bare board region is closer to the air inlet than the chip region, and the plurality of hash chips are disposed in the chip region; the first heat sink is mounted on the first surface of the substrate, and the first heat sink has an extension structure opposite to the bare board region; the seal is disposed at edge regions of the extension structure and the bare board region close to the air inlet; the first direction is a direction in which the air inlet and the air outlet are opposite to each other.

Preferably, the seal is located between the bare board region and the extension structure.

Preferably, the seal has a strip-shaped plate-like structure, and opposite faces thereof are fitted against the first heat sink and the substrate, respectively.

Preferably, the extension structure is flush with the bare board region one a side close to the air inlet; the seal is fitted against side walls of the extension structure and the bare board region close to the air inlet.

Preferably, the seal is a strip-shaped structure, and comprises a first section, a second section and a third section, wherein the first section is located at edge regions of the extension structure and the bare board region close to the air inlet, and extends along the edges of the edge regions; the second section and the third section are respectively connected to both ends of the first section in a bent manner, and are respectively located at two edge regions of the first heat sink and the bare board region opposite to each other in a second direction; the second direction is perpendicular to the first direction.

Preferably, a projection of the chip region in the first direction is located within a projection range of the seal.

Preferably, the seal is a silicone rubber member or a sealing foam.

Preferably, the seal is a thermally conductive silicone rubber member.

Preferably, a windward surface of the extension structure towards the air inlet is obliquely disposed, and one end of the windward surface away from the air inlet is inclined in a direction away from the hash board as compared with an end closer to the air inlet.

Preferably, a plurality of said first heat sinks are disposed on the same side of the same substrate in the second direction, and the plurality of first heat sinks cover the plurality of hash chips in the second direction; the second direction is perpendicular to the first direction; the seal is disposed at an edge of each of the first heat sinks close to the air inlet;
a second heat sink is disposed on a second surface of the substrate facing away from the hash chips, the second heat sink is fitted against and covers the substrate, and the supercomputing unit is connected with the housing via the second heat sink.

A second aspect of the present application provides a data center comprising the supercomputing device according to any one of the above.

In the supercomputing device according to the present application, the seal is added between the hash board and the first heat sinks at a position of the supercomputing unit close to the air inlet, so that the gap between the hash board and the first heat sinks is blocked at the air intake end on the side close to the air inlet. Therefore, even though there is a large airflow in the airflow channel from the air inlet to the air outlet and there is a large amount of foreign matter such as dust, the foreign matter such as dust will be blocked by the seal upon approaching the whole supercomputing unit so that foreign matter such as dust substantially will not enter between the hash board and the first heat sinks, thereby substantially reducing the deposition of the foreign matter such as dust on the hash board even on the hash chips, thereby reducing the probability of the short-circuiting of the hash board caused by the foreign matter such as dust, and ensuring the heat dissipation effect of the hash chips. Furthermore, the provision of the extension structure increases the heat dissipation area of the first heat sink, thereby avoiding the influence on the heat dissipation effect of the whole hash board since there is not an airflow directly flowing through the hash chips.

Other advantageous effects of the present application will be described by introducing specific technical features and technical solutions in specific embodiments. Those skilled in the art can understand the advantageous technical effects resulting from the technical features and technical solutions by reading through the introduction of these technical features and technical solutions.

### BRIEF DESCRIPTION OF THE DRAWINGS

Hereinafter, preferred embodiments of the present application will be described with reference to the following figures.
FIG. 1 is a cross-sectional view of a preferred embodiment of a supercomputing device provided by the present application;
FIG. 2 is a structural schematic view of a preferred embodiment of a supercomputing unit in the supercomputing device provided by the present application;
FIG. 3 is a partially enlarged view of position I in FIG. 2;
FIG. 4 is a schematic view illustrating relative positions of a preferred embodiment of a hash board and a seal in the supercomputing device provided by the present application;
FIG. 5 is a schematic view illustrating relative positions of another preferred embodiment of the hash board and the seal in the supercomputing device provided by the present application;
FIG. 6 is a structural schematic view of another preferred embodiment of the supercomputing unit in the supercomputing device provided by the present application.

**In** the figures:
10 Housing; 11 Air inlet; 12 Air outlet;
20 Supercomputing unit; 21 Hash board; 211 Substrate; 2111 Bare board region; 2112 Chip region; 212 Hash chip; 22 First heat sink; 221 Heat dissipation panel; 222 Fin; 223 Extension structure; 2231 Windward surface; 23 Seal; 231 First section; 232 Second section; 233 Third section; 24 Second heat sink.

### DETAILED DESCRIPTION OF EMBODIMENTS

The present application will be described based on embodiments, but the present application is not only limited to these embodiments. In the following detailed depictions of the present application, some specific details are presented in detail. In order to avoid confusing the spirit of the present application, well-known methods, processes, procedures and elements are not described in detail.

In addition, those having ordinary skill in the art should appreciate that the figures are provided herein for illustrative purposes and are not necessarily drawn to scale.

Unless the context clearly requires otherwise, words such as "comprise" and "contain" throughout in the whole description and the claim set should be understood as having the meaning of containing rather than exclusive or exhaustive, i.e., as having the meaning of "including but not limited to".

In the description of the present application, it is to be understood that the terms "first", "second" etc. are used for descriptive purposes only and are not to be understood as indicating or implying relative importance. In addition, in the description of the present application, the meaning of "a plurality of" means two or more unless otherwise specified.

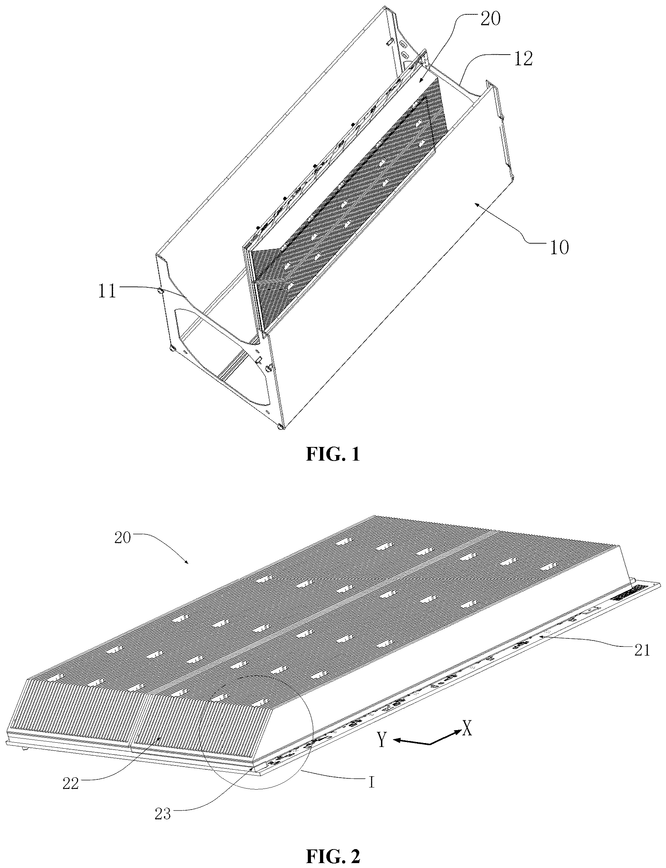

The present application provides a supercomputing device for processing data, information, etc., e.g., for processing data and information in virtual currency. Referring to FIG. 1 through FIG. 6, the supercomputing device comprises a housing 10 and a supercomputing unit 20, the housing 10 having an air inlet 11 and an air outlet 12 which are disposed opposite to each other. Specifically, the housing 10 may be a rectangular parallelepiped structure or a quasi-rectangular parallelepiped structure, the air inlet 11 is disposed on a first end face of the housing 10, and the air outlet 12 may be disposed on a second end face of the housing 10, so that the air inlet 11, an inner cavity of the housing 10 and the air outlet 12 form an airflow channel, and the airflow is blown out from the air inlet 11 through the inner cavity of the housing 10 out of the air outlet 12. The supercomputing unit 20 is mounted in the housing 10 and located between the air inlet 11 and the air outlet 12. The supercomputing unit 20 comprises a hash board 21, a first heat sink 22 and a seal 23. The hash board 21 comprises a substrate 211 and a plurality of hash chips 212. A first surface of the substrate 211 is provided with a chip region 2112 and a bare board region 2111 in a first direction. The bare board region 2111 is closer to the air inlet 11 than the chip region 2112. The plurality of hash chips 212 are disposed in the chip region 2112, i.e., the substrate 211 has two opposite surfaces, namely, a first surface and a second surface. The plurality of hash chips 212 are disposed on the same surface, namely, the first surface of the substrate 211; the first heat sink 22 is mounted on the first surface of the substrate 211, i.e., mounted on the surface of the substrate 211 where the hash chips 212 are disposed. The first heat sink 22 has an extension structure 223 opposite to the bare board region 2111, i.e., the extension structure 223 at least partially extends beyond the chip region 2112. It may be appreciated that there is a gap between the substrate 211 and the first heat sink 22. The seal 23 is disposed at edge regions of the extension structure 223 and the bare board region 2111 close to the air inlet 11, i.e., the seal 23 is disposed on a side of the supercomputing unit 20 close to the air inlet 11 to seal an air intake end of the gap close to the air inlet 11. The first direction X is a direction in which the air inlet 11 and the air outlet 12 are opposite to each other.

In the supercomputing device according to the present application, the seal 23 is added between the hash board 21 and the first heat sink 22 at a position of the supercomputing unit 20 close to the air inlet 11, so that the gap between the hash board 21 and the first heat sink 22 is blocked at the air intake end on the side close to the air inlet 11, so that each hash chip 212 is located on the side of the seal 23 away from the air inlet 11. Therefore, even though there is a large airflow in the airflow channel from the air inlet 11 to the air outlet 12 and there is a large amount of foreign matter such as dust, the foreign matter such as dust will be blocked by the seal 23 upon approaching the whole supercomputing unit 20 so that foreign matter such as dust substantially will not enter between the hash board 21 and the first heat sink 2, thereby substantially reducing the deposition of the foreign matter such as dust on the hash board 21 even on the hash chips 212, thereby reducing the probability of the short-circuiting of the hash board 2 caused by the foreign matter such as dust, and alleviating corrosion of the hash board 212 on account of the deposition of the foreign matter such as dust. Furthermore, since the coverage of foreign matter such as dust is reduced, the heat dissipation effect of the hash chips 212 and even the whole hash board 21 is ensured. Furthermore, the provision of the extension structure increases the heat dissipation area of the first heat sink, thereby avoiding the influence on the heat dissipation effect of the whole hash board since there is not an airflow directly flowing through the hash chips on the substrate 211.

The housing 10 may be provided with an air ingress fan at the air inlet 11, or with an air egress fan at the air outlet 12, or provided with the air ingress fan and the air egress fan simultaneously, or provided with a grille at the air inlet 11 and air outlet 12 to reduce entry of foreign matter such as dust into the airflow channel and further reduce the probability that the foreign matter such as dust deposits on the hash chips 212.

Further referring to FIG. 2, FIG. 4 and FIG. 5, the plurality of hash chips 212 may be arranged in a plurality of chip sets in a second direction Y on the substrate 212, each chip set comprising a plurality of hash chips 212 arranged in the first direction X. The second direction Y and the first direction X are two directions substantially parallel to the substrate 211 and perpendicular to each other. Specifically, the second direction Y is an arrangement direction described hereunder and may coincide with a height direction of the housing 10; the first direction X coincides with a depth direction of the housing 10 and is also the direction in which the air inlet 11 is opposite to the air outlet 12. Specifically, the substrate 211 has a chip region 2112 and a bare board region 2111, the bare board region 2111 is located at an edge region of the substrate 211 close to the air inlet 11, the chip region 2112 is located on a side of the bare board region 2111 away from the air inlet 11, i.e., the bare board region 2111 and the chip region 2112 are disposed in the first direction X, and the bare board region 2111 is closer to the air inlet 11 than the chip region 2112. In the embodiment, the plurality of hash chips 212 are disposed on the chip region 2112, and the bare board region 2111 is not provided with the hash chips 212. It may be appreciated that the substrate 211 is further provided with other elements such as other chips, wirings, interface terminals etc. These elements may be disposed or not disposed in the chip region 2112.

The first heat sink 22 comprises a heat dissipation panel 221 and fins 222. A first surface of the heat dissipation panel 221 faces towards the hash board 21 and may be specifically fitted against the hash chips 212 to increase the thermal conduction efficiency. A second surface of the heat dissipation panel 221 is provided with a plurality of fins 222 which each extend in the first direction X, i.e., each fin 222 extends in the direction in which the air inlet 11 and air outlet 12 are opposite to each other. The plurality of fins 222 are disposed spaced-apart in the second direction Y, i.e., a space is left between adjacent fins 222 to enable the airflow to better take away the heat thereon. In order to increase the heat dissipation effect of the first heat sink 22, the thickness of the first heat sink 22 may be set large, and specifically the size of extension of the fins 222 out of the heat dissipation panel 221 may be set large.

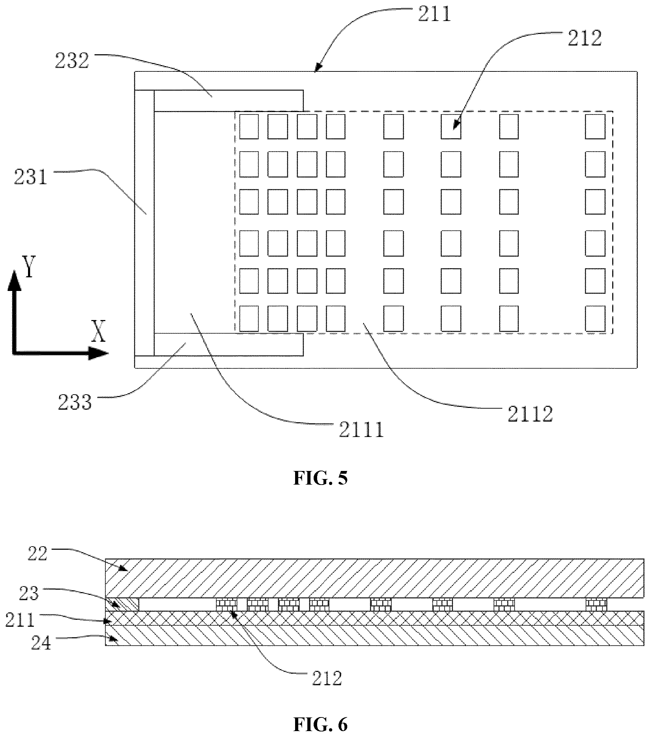

The seal 23 may have a strip-shaped structure extending in the arrangement direction, i.e., the above-mentioned second direction Y, to seal the air intake end of the gap between the entire first heat sink 23 and the substrate 211. Specifically, the seal 23 may extend only in the second direction Y; in a preferred embodiment, as shown in FIG. 5, the seal 23 comprises a first section 231, a second section 232 and a third section 233, wherein the first section 231 is located at edge regions of the extension structure 223 and the bare board region 2111 close to the air inlet 11, and extends along the edges of the edge regions, i.e., the first section 231 extends substantially in the second direction Y; the second section 232 and the third section 233 are respectively connected to both ends of the first section 231 in a bent manner, and are respectively located at two edge regions of the first heat sink 22 and the bare board region 2111 opposite to each other in the second direction Y, that is to say, the second section 232 and the third section 233 extend substantially in the first direction X, and may be arranged only in the bare board region 2111, or may continue to extend towards the side where the chip region 2112 is located, such as to substantially enclose the chip region 2112 in the whole seal 23. With the seal 23 having this structure being provided, deposition of foreign matter such as dust adjacent the hash chips 212 can be further reduced.

Further preferably, the seal 23 may have a strip-shaped plate-like structure, and opposite surfaces of the seal 23 are fitted against the first heat sink 22 and the substrate 211 to improve the sealing performance between the first heat sink 22 and the substrate 211 on the side of the air inlet 11.

In one embodiment, the seal 23 may be a member having a thermally conductive performance, such as a thermally conductive adhesive strip, to increase heat transfer between the hash board 21 and the first heat sink 22 while sealing. In another embodiment, the seal 23 is a member having certain compressive properties, and may be a silicone rubber member or a sealing foam, to increase the fit between the seal 23 and the substrate 211 and the first heat sink 22. Especially in a case where the parts of the substrate 211 and the first heat sink 22 in contact with the seal 23 are not flat enough, the seal 23 substantially improves the sealing performance between the substrate 211 and the first heat sink 22. Especially in the embodiment where the seal 23 is disposed between the bare board region 2111 and the extension structure (described in detail below), such a seal 23 can better increase the sealing performance for the air intake end upon assembling by a pressing force applied to the seal 23 by the substrate 211 and the first heat sink 22, and meanwhile the reliability in mounting the seal 23 can also be improved. In a preferred embodiment, the seal 23 is a thermally conductive silicone member to improve both the sealing performance of the air intake end and the heat dissipation efficiency of the hash board 21.

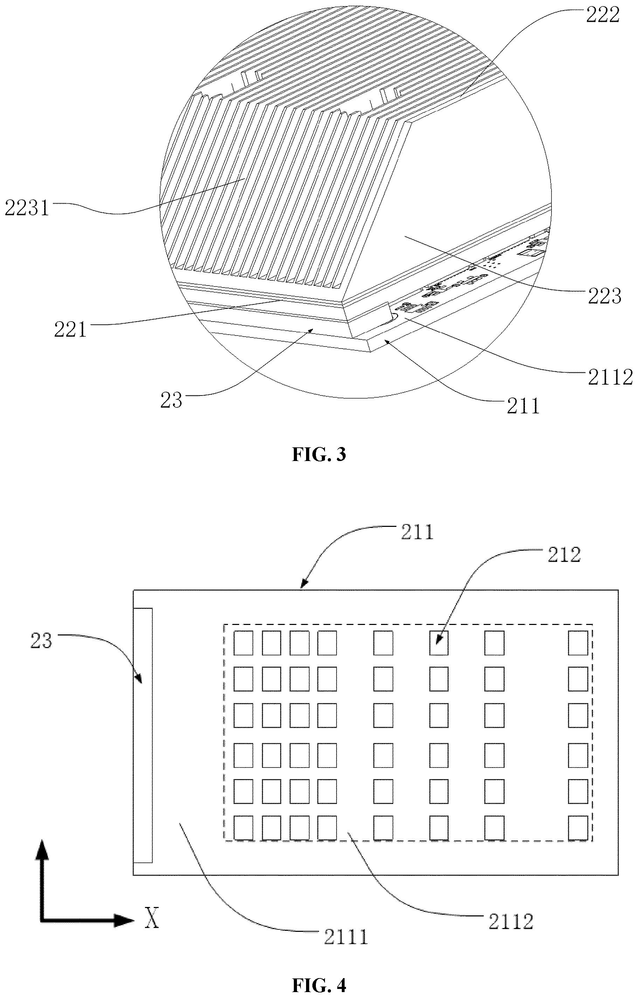

In one embodiment, on the side where the air inlet 11 is located, side walls of the first heat sink 22 and the hash board 21 are arranged in a staggered manner, i.e., are not flush, for example, the first heat sink 22 may extend beyond the hash board 21, and specifically, the heat dissipation panel 221 may extend beyond the substrate 211; for another example, the substrate 211 may also extend beyond the first heat sink 22 on the side close to the air inlet 11. In another embodiment, on the side where the air inlet 11 is located, side walls of the first heat sink 22 and the hash board 21 are disposed flush with each other. As shown in FIG. 2 and FIG. 3, on the side close to the air inlet 11, the substrate 211 and the first heat sink 22 may be flush with each other, i.e., the side walls of the extension structure 223 and the bare board region 2111 close to the air inlet are flush with each other to reduce the air resistance of the airflow on the air inlet side of the supercomputing unit 20.

No matter which one of the above manners in which the first heat sink 22 and the hash board 21 are disposed on the air inlet side, the seal 23 may be disposed directly between the first heat sink 22 and the hash board 21 to seal the air intake end, or may also achieve sealing in a manner of being disposed on the sidewalls of the extension structure 23 and the bare board region 2111. In the embodiment where the first heat sink 22 and the hash board 21 are not flush on the side where the air inlet 11 is located, the seal 23 may be disposed on a side wall of one of the first heat sink 22 and the substrate 211 close to the air inlet 11 and is sealed with a bottom surface of the other of the first heat sink 22 and the substrate 211. For example, if the first heat sink 22 extends beyond the hash board 21, the seal may be fitted against the side wall of the substrate 211 close to the air inlet and is fitted against the bottom surface of the first heat sink 22, and is specifically sealed with the first surface of the heat dissipation panel 221; alternatively, the seal may be disposed directly between the extension structure 223 and the bare board region 2111.

In one embodiment, the extension structure 23 is flush with the bare board region 2111 at a side close to the air inlet 11, i.e., the side walls of the first heat sink 22 and the hash board 21 on the side close to the air inlet 11 are disposed flush with each other; the seal 23 is disposed on the side walls of the first heat sink 22 and the substrate 211, i.e., located on the side wall of the substrate 211 close to the air inlet 11 and on the side wall of the first heat sink 22 close to the air inlet 11 simultaneously.

In a preferred embodiment, the seal 23 is located between the first heat sink 22 and the substrate 211. Specifically, as shown in FIG. 2 and FIG. 3, the seal 23 is located between the bare board region 2111 and the extension structure 223 such that the hash chips 212 are all located on the side of the seal 23 facing away from the air inlet 11, and meanwhile the seal 23 is tightly pressed against the first heat sink 22 by the hash board 21 to improve the sealing performance between the substrate 211 and the first heat sink 22. When the seal 23 is the strip-shaped plate-like structure, two opposite faces of the plate-like structure are fitted against the extension structure 223 and the bare board region 2111, respectively, i.e., the extension structure 223, the seal 23 and the bare board region 2111 form a sandwich-like structure. In particular, when the seal 23 is the strip-shaped plate-like structure, both opposite surfaces of the seal 23 are fitted against the extension structure 223 and the bare board region 2111, respectively.

A windward surface 2231 of the extension structure 223 towards the air inlet 11 is obliquely disposed, i.e., one end of the extension structure 223 away from the air inlet 11 is inclined in a direction away from the hash board 21 as compared with an end closer to the air inlet 11, as shown in FIG. 2 and FIG. 3. The extension structure 223 being set as the inclined structure can function to guide the airflow and more importantly can prevent foreign matter such as dust in the airflow from depositing on the end wall of the first heat sink 22 to affect the flow of the entire airflow, thereby further improving the performance of the entire supercomputing unit 20.

In order to better prevent foreign matter such as dust from depositing on the hash chips 212 and other elements on the substrate 211, in the direction, i.e., the aforesaid first direction X in which the air inlet 11 and the air outlet 12 are opposite, a projection of the chip region 2112 is located within a projection range of the seal 23, i.e., both ends of the seal 23 in the second direction Y extend beyond the chip region 2112. In another embodiment, a projected profile of chip region 2112 coincides with that of the seal 23.

Only one first heat sink 22 may be disposed on the same side of the same substrate 211, and the first heat sink 22 covers each hash chip 212, i.e., the first heat sink 22 is fitted against all the hash chips 212 simultaneously. In a preferred embodiment, a plurality of first heat sinks 22 are disposed on the same side of the same substrate 211 in the arrangement direction, i.e., the above-mentioned second direction Y, and the plurality of first heat sinks 22 cover the plurality of hash chips 212 in the arrangement direction, for example, two, three or more first heat sinks 22 are disposed, wherein FIG. 2 shows a structure provided with two first heat sinks 22, and each of these first heat sinks 22 covers part of the hash chips 212. As such, there is smaller requirement for an area of contact of each first heat sink 22 and the hash chips 212, thereby reducing the difficulty in processing the first heat sinks 22, enabling better fitting of the first heat sinks 22 and the hash chips 212 and enhancing the heat dissipation efficiency of the hash chips 212. The above-mentioned arrangement direction is parallel to the substrate 211 and perpendicular to the direction in which the air inlet 11 and air outlet 12 are opposite to each other. Preferably, two first heat sinks 22 are disposed on one surface of the same substrate 211 on which the has chips 212 are disposed. Providing two first heat sinks 22 can not only reduce the difficulty in processing the first heat sinks 22 and ensure the fitting area between the first heat sinks 22 and the hash chips 212, but also reduce the time for assembling the first heat sinks 22 with the hash board 21.

In order to further improve the heat dissipation effect of the whole hash board 21, a second heat sink 24 may be disposed on a surface of the substrate 211 facing away from the hash chips 212. As shown in FIG. 6, the second heat sink 24 is fitted against and covers the substrate 211. The second heat sink 24 may employ the structure of the first heat sink 22, e.g., also comprise a heat dissipation panel and fins. Considering that the surface of the substrate 211 facing away from the hash chips 212 is substantially flat, in a preferred embodiment, one second heat sink 24 is disposed on the surface of the substrate 211 facing away from the hash chips 212, and the second heat sink 24 is fitted against the substrate 211, i.e., the seal 23 may not be disposed between the second heat sink 24 and the substrate 211.

The supercomputing unit 20 and the housing 10 may be mounted via the first heat sink 22; in the embodiment provided with the second heat sink 24, the supercomputing unit 20 may be mounted on the housing 10 via the second heat sink 24; for example, insertion slots may be disposed on an inner wall of the housing 10, both ends of the second heat sink 24 in the first direction are set to extend beyond the hash board 21 and the first heat sink 22, and the extend-beyond parts are inserted into the insertion slots on the housing for connection. In this way, the structure and arrangement manner of the first heat sink 22 will not be affected since the second heat sink 24 needs to be mounted on the housing 10. That is, the second heat sink 24 can not only improve the heat dissipation effect of the hash board 21 but also facilitate the mounting of the whole supercomputing unit 20.

The present application further provides a data center, comprising the supercomputing device according to any of the above embodiments. The data center may comprise only one supercomputing device or two or more supercomputing devices.

Those skilled in the art can appreciate that the above-described preferred solutions may be freely combined and superimposed without conflict.

It should be appreciated that the above-described embodiments are merely exemplary rather than limiting, and that various obvious or equivalent modifications to and substitutes for the above-described details made by those skilled in the art without departing from the basic principles of the present application, are all included within the scope of the appended claims of the present application.

## Claims

1. A supercomputing device, wherein the supercomputing device comprises a housing and a supercomputing unit;
the housing has an air inlet and an air outlet which are disposed opposite to each other;
the supercomputing unit is mounted in the housing and located between the air inlet and the air outlet;
the supercomputing unit comprises a hash board, a first heat sink and a seal, the hash board comprises a substrate and a plurality of hash chips, a first surface of the substrate is provided with a chip region and a bare board region in a first direction, the bare board region is closer to the air inlet than the chip region, and the plurality of hash chips are disposed in the chip region; the first heat sink is mounted on the first surface of the substrate, and the first heat sink has an extension structure opposite to the bare board region; the seal is disposed at edge regions of the extension structure and the bare board region close to the air inlet; the first direction is a direction in which the air inlet and the air outlet are opposite to each other.

2. The supercomputing device according to claim 1, wherein the seal is located between the bare board region and the extension structure.

3. The supercomputing device according to claim 2, wherein the seal has a strip-shaped plate-like structure, and opposite faces thereof are fitted against the first heat sink and the substrate, respectively.

4. The supercomputing device according to claim 1, wherein the extension structure is flush with the bare board region one a side close to the air inlet; the seal is fitted against side walls of the extension structure and the bare board region close to the air inlet.

5. The supercomputing device according to claim 1, wherein the seal is a strip-shaped structure, and comprises a first section, a second section and a third section, the first section is located at edge regions of the extension structure and the bare board region close to the air inlet, and extends along the edges of the edge regions; the second section and the third section are respectively connected to both ends of the first section in a bent manner, and are respectively located at two edge regions of the first heat sink and the bare board region opposite to each other in a second direction; the second direction is perpendicular to the first direction.

6. The supercomputing device according to claim 1, wherein a projection of the chip region in the first direction is located within a projection range of the seal.

7. The supercomputing device according to claim 1, wherein the seal is a silicone rubber member or a sealing foam.

8. The supercomputing device according to claim 1, wherein the seal is a thermally conductive silicone rubber member.

9. The supercomputing device according to claim 1, wherein a windward surface of the extension structure towards the air inlet is obliquely disposed, and one end of the windward surface away from the air inlet is inclined in a direction away from the hash board as compared with an end closer to the air inlet.

10. The supercomputing device according to any of claims 1-9, wherein a plurality of said first heat sinks are disposed on the same side of the same substrate in the second direction, and the plurality of said first heat sinks cover the plurality of hash chips in the second direction; the second direction is perpendicular to the first direction; the seal is disposed at an edge of each of the first heat sinks close to the air inlet;
a second heat sink is disposed on a second surface of the substrate facing away from the hash chips, the second heat sink is fitted against and covers the substrate, and the supercomputing unit is connected with the housing via the second heat sink.

11. A data center comprising the supercomputing device according to any of claims 1-10.
